# EUROPEAN PATENT APPLICATION

(11) **EP 3 012 871 A1**
(43) Date of publication of application: **27.04.2016**
(21) Application number: 15159811.7
(22) Date of filing: 19.03.2015
(51) Int. Cl.: H01L 31/0216, H01L 31/0224, H01L 31/0288, H01L 31/18

(54) **Solar cell and method for manufacturing the same**

(30) Priority: 24.10.2014 TW 103136817
(71) Applicant: Gintech Energy Corporation, Jhunan Township, Miaoli County 350 (TW)
(72) Inventor: Wu, Chung-Han, Jhunan, Miaoli (TW); Chen, Kuei-Po, Jhunan, Miaoli (TW); Wu, Hsing-Hua, 350 Miaoli County (TW); Lin, Hsin-Cheng, 350 Miaoli County (TW); Ou, Nai-Tien, 350 Miaoli County (TW); Huang, Kuei-Wu, 350 Miaoli County (TW)
(74) Representative: Granleese, Rhian Jane

(57) **Abstract**

A solar cell includes a semiconductor substrate, a boron back surface field (BSF) layer, a passivation layer, a back electrode layer and an aluminum local BSF layer. The semiconductor substrate has a front surface and a back surface opposite to each other. The boron BSF layer is disposed in the semiconductor substrate beneath the back surface. The passivation layer is disposed over the boron BSF layer and has an opening through the passivation layer. The back electrode layer is disposed in the opening. The aluminum local BSF layer is disposed in the semiconductor substrate beneath the opening and in contact with the boron BSF layer and the back electrode layer.

## Description

### BACKGROUND

### Field of Invention

The present disclosure relates to a silicon-based solar cell and a method for manufacturing the silicon-based solar cell.

### Description of Related Art

Solar cell is an environmentally friendly energy source, which can directly convert solar energy into electrical energy. An electric power generation process of the solar cell does not produce greenhouse gases such as carbon dioxide, and thus it does not pollute the environment. When light is irradiated on the solar cell, current is generated by interaction between photons and free electrons in conductor or semiconductor. Currently available solar cells can be classified into silicon-based semiconductor solar cells, dye-sensitized solar cells and organic material solar cells, based on the host material. The silicon-based semiconductor solar cells exhibit better photoelectric conversion efficiency, but there is still room for improvement.

The silicon-based semiconductor solar cell typically has a full aluminum back surface field (BSF) layer. However, recombination rate of the aluminum BSF layer of such silicon-based semiconductor solar cell is too fast, resulting in deterioration of cell conversion efficiency. To overcome the problem, a silicon-based solar cell including a local BSF layer is provided. Nevertheless, such silicon-based solar cell exhibits poor conductivity of a back surface. Accordingly, there is a need of a novel solar cell and a method for manufacturing the same to improve the above problems.

### SUMMARY

The present disclosure provides a solar cell including a boron back surface field (BSF) layer, an aluminum local BSF layer and a passivation layer. The boron BSF layer and the aluminum local BSF layer are configured to increase conductivity of a back surface and effectively increase carrier collection efficiency. The passivation layer is configured to enhance passivation effect of the back surface to increase conversion efficiency of the solar cell, and thus to fully overcome the problems faced in the prior art.

The present disclosure provides a solar cell including a semiconductor substrate, a boron BSF layer, a passivation layer, a back electrode layer and an aluminum local BSF layer. The semiconductor substrate has a front surface and a back surface opposite to each other. The boron BSF layer is disposed in the semiconductor substrate beneath the back surface. The passivation layer is disposed over the boron BSF layer and has an opening through the passivation layer. The back electrode layer is disposed in the opening. The aluminum local BSF layer is disposed in the semiconductor substrate beneath the opening and in contact with the boron BSF layer and the back electrode layer.

According to one embodiment of the present disclosure, the back electrode layer further covers the passivation layer.

According to one embodiment of the present disclosure, the passivation layer is not completely covered by the back electrode layer.

According to one embodiment of the present disclosure, the boron BSF layer has an opening, and the opening of the boron BSF layer is substantially aligned with the opening of the passivation layer.

According to one embodiment of the present disclosure, the passivation layer includes: a first passivation layer in contact with the boron BSF layer and including aluminum oxide, silicon oxide, silicon oxynitride or a combination thereof; and a second passivation layer disposed over the first passivation layer and including silicon nitride.

According to one embodiment of the present disclosure, the solar cell further includes a first doped layer disposed in the semiconductor substrate beneath the front surface; a second doped layer disposed in the semiconductor substrate beneath the front surface and adjacent to the first doped layer, the first doped layer having a conductivity type the same as a conductivity type of the second doped layer, the second doped layer having a doped concentration greater than a doped concentration of the first doped layer; and a front electrode layer in contact with the second doped layer.

The present disclosure further provides a method for manufacturing a solar cell, which includes: providing a semiconductor substrate having a front surface and a back surface opposite to each other; forming a boron BSF layer in the semiconductor substrate beneath the back surface; forming a passivation layer over the boron BSF layer; forming an opening through the passivation layer; disposing an aluminum paste in the opening; and sintering the aluminum paste to form an aluminum local BSF layer in the semiconductor substrate beneath the opening.

According to one embodiment of the present disclosure, forming the boron BSF layer in the semiconductor substrate beneath the back surface is conducted by diffusing or ion implanting boron into the semiconductor substrate beneath the back surface.

According to one embodiment of the present disclosure, forming the boron BSF layer in the semiconductor substrate beneath the back surface includes: forming a boron-containing passivation material layer over the back surface of the semiconductor substrate, the boron-containing passivation material layer including boron and a passivation material; and diffusing the boron of the boron-containing passivation material layer into the semiconductor substrate beneath the back surface to form the boron BSF layer.

According to one embodiment of the present disclosure, diffusing the boron of the boron-containing passivation material layer into the semiconductor substrate beneath the back surface and sintering the aluminum paste are simultaneously performed.

According to one embodiment of the present disclosure, forming the boron BSF layer in the semiconductor substrate beneath the back surface includes: forming a boron source layer over the back surface of the semiconductor substrate; diffusing boron of the boron source layer into the semiconductor substrate beneath the back surface to form the boron BSF layer; and removing the boron source layer.

According to one embodiment of the present disclosure, the boron source layer includes boron paste, borosilicate glass or a combination thereof.

According to one embodiment of the present disclosure, the method further includes diffusing phosphorus into the semiconductor substrate beneath the front surface.

According to one embodiment of the present disclosure, diffusing the boron of the boron source layer into the semiconductor substrate beneath the back surface and diffusing the phosphorus into the semiconductor substrate beneath the front surface are conducted by a same heat treatment.

### BRIEF DESCRIPTION OF THE DRAWINGS

The invention can be more fully understood by reading the following detailed description of the embodiment, with reference made to the accompanying drawings as follows:
Fig. 1 is a cross-sectional view of a solar cell according to one embodiment of the present disclosure;
Fig. 2 is a cross-sectional view of a solar cell according to another embodiment of the present disclosure;
Figs. 3A-3F are cross-sectional views at various stages of manufacturing a solar cell according to one embodiment of the present disclosure;
Figs. 4A-4F are cross-sectional views at various stages of manufacturing a solar cell according to another embodiment of the present disclosure; and
Figs. 5A-5F are cross-sectional views at various stages of manufacturing a solar cell according to further embodiment of the present disclosure.

### DETAILED DESCRIPTION

The present disclosure is described by the following specific embodiments. Those with ordinary skill in the arts can readily understand the other advantages and functions of the present invention after reading the disclosure of this specification. The present disclosure can also be implemented with different embodiments. Various details described in this specification can be modified based on different viewpoints and applications without departing from the scope of the present disclosure.

As used herein, the term "about" or "substantially" is used to modify any tiny variation or modification not affecting the essence of its nature. Unless otherwise noted in the embodiment, the term of "about" or "substantially" means that an error range is within 20%, preferably within 10%, more preferably within 5%.

As mentioned above, the silicon-based solar cell having the full aluminum BSF layer has high recombination rate, resulting in deterioration of cell conversion efficiency, and the silicon-based solar cell having the local BSF layer exhibits poor conductivity of the back surface. Accordingly, the present disclosure provides a solar cell including a boron BSF layer, an aluminum local BSF layer and a passivation layer. The boron BSF layer and the aluminum local BSF layer are configured to increase conductivity of a back surface and effectively increase carrier collection efficiency. The passivation layer is configured to enhance passivation effect of the back surface to increase conversion efficiency of the solar cell, and thus to fully overcome the problems faced in the prior art.

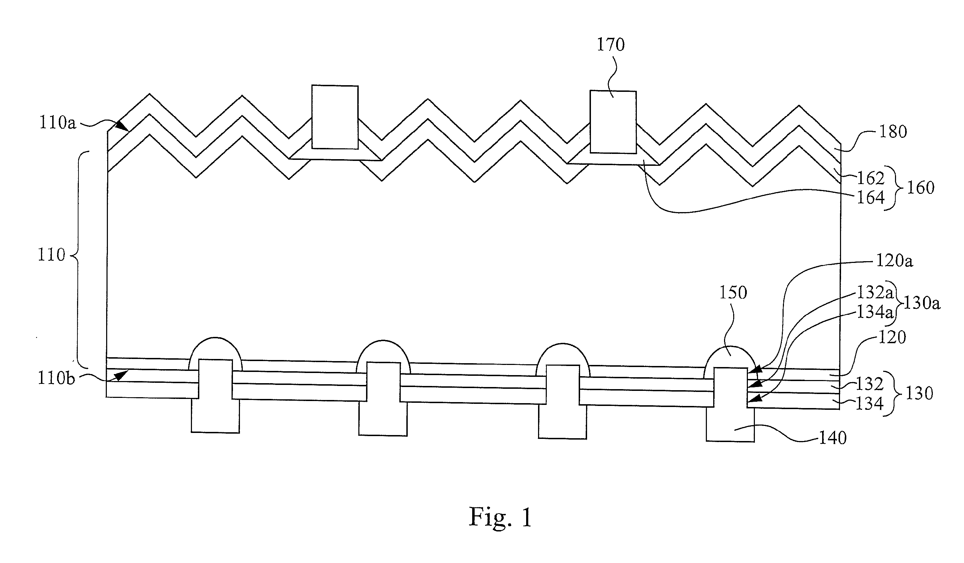

Fig. 1 is a cross-sectional view of a solar cell according to one embodiment of the present disclosure. The solar cell includes a semiconductor substrate 110, a boron BSF layer 120, a passivation layer 130, a back electrode layer 140 and an aluminum local BSF layer 150.

The semiconductor substrate 110 has a front surface 110a and a back surface 110b opposite to each other. As used herein, the position beneath the back surface 110b is defined as a side toward the semiconductor substrate 110, and the position over the back surface 110b is defined as another side away from the semiconductor substrate 110 to clearly define relative positions of the boron BSF layer 120, the passivation layer 130, the back electrode layer 140 and the aluminum local BSF layer 150.

The semiconductor substrate 110 may be a silicon substrate, such as a single-crystal silicon substrate, polysilicon substrate or amorphous silicon substrate. In one embodiment, the semiconductor substrate 110 is a p-type silicon substrate. In one embodiment, the front surface 110a of the semiconductor substrate 110 is a rough surface to reduce reflectivity of incident light.

The boron BSF layer 120 is disposed in the semiconductor substrate 110 beneath the back surface 110b. In the embodiment, the boron BSF layer 120 has an opening 120a through the boron BSF layer 120. Of course, the boron BSF layer 120 may have a plurality of openings 120 separated from each other and through the boron BSF layer 120. In one embodiment, the boron BSF layer 120 is formed using high temperature diffusion or ion implantation. In one embodiment, the boron BSF layer 120 has a doped concentration in a range of about 10¹⁵ atoms/cm³ to about 5x10²² atoms/cm³. In one embodiment, the boron BSF layer 120 has a resistance in a range of about 10 ohms/square to about 200 ohms/square.

The passivation layer 130 is disposed over the boron BSF layer 120. The passivation layer 130 has an opening 130a through the passivation layer 130. Of course, the passivation layer 130 may have a plurality of openings 130a separated from each other and through the passivation layer 130. In the embodiment, the opening 130a of the passivation layer 130 is substantially aligned with the opening 120a of the boron BSF layer 120. In one embodiment, the passivation layer 130 includes silicon oxide, silicon nitride, silicon oxynitride, aluminum oxide, other suitable materials or a combination thereof.

In one embodiment, the passivation layer 130 includes a first passivation layer 132 and a second passivation layer 134. The first passivation layer 132 is in contact with the boron BSF layer 120 and includes aluminum oxide, silicon oxide or a combination thereof. The second passivation layer 134 is disposed over the first passivation layer 132 and includes silicon nitride. The first passivation layer 132 and the second passivation layer 134 may respectively have an opening 132a and an opening 134a, and the opening132a and the opening 134a construct an opening 130a. The second passivation layer 134 is configured to protect the first passivation layer 132 to avoid the first passivation layer 132 from deterioration or corrosion due to in contact with the back electrode layer 140. Further, the second passivation layer 134 can be used to reflect light, for example, to reflect long-wavelength light.

The back electrode layer 140 is disposed in the opening 130a. In the embodiment, the back electrode layer 140 is disposed in the opening 130a and the opening 120a. In one embodiment, the back electrode layer 140 includes any suitable metal material, such as aluminum. In one embodiment, the back electrode layer 140 is formed by sintering an aluminum paste. It is noteworthy that, in the embodiment, the passivation layer 130 is not completely covered by the back electrode layer 140, leading to greater light receiving area to increase absorption of light.

The aluminum local BSF layer 150 is disposed in the semiconductor substrate 110 beneath the opening 120a and in contact with the boron BSF layer 120 and the back electrode layer 140. In one embodiment, the back electrode layer 140 includes aluminum, and aluminum ions may be react with silicon of the semiconductor substrate 110 at high temperature to form aluminum silicon alloy, and thus to form the aluminum local BSF layer 150. In one embodiment, the aluminum local BSF layer 150 has a doped concentration greater than that of the boron BSF layer 120. In one embodiment, the doped concentration of the aluminum local BSF layer 150 is in a range of about 10¹⁵ atoms/cm³ to about 5x10²² atoms/cm³.

As used herein, the position beneath the front surface 110a is defined as a side toward the semiconductor substrate 110, and the position over the front surface 110a is defined as another side away from the semiconductor substrate 110. In one embodiment, the solar cell further includes a first doped layer 162, a second doped layer 164 and a front electrode layer 170. The first doped layer 162 is disposed in the semiconductor substrate 110 beneath the front surface 110a. The second doped layer 164 is disposed in the semiconductor substrate 110 beneath the front surface 110a and adjacent to the first doped layer 162. The first doped layer 162 has a conductivity type the same as a conductivity type of the second doped layer 164. In one embodiment, the conductivity type of the first doped layer 162 and the second doped layer 164 is opposite to that of the semiconductor substrate 110. In one embodiment, the front electrode layer 170 includes any suitable metal material, such as silver. In one embodiment, the front electrode layer is formed by sintering a silver paste.

In one embodiment, the second doped layer 164 has a doped concentration greater than a doped concentration of the first doped layer 162. In one embodiment, the doped concentration of the first doped layer 162 is in a range of about 10¹⁵ atoms/cm³ to about 5x10²² atoms/cm³. In one embodiment, the doped concentration of the second doped layer 164 is in a range of about 10¹⁵ atoms/cm³ to about 5x10²² atoms/cm³. In one embodiment, the first doped layer 162 has a resistance in a range of about 10 ohms/square to about 200 ohms/square. In one embodiment, the second doped layer 164 has a resistance in a range of about 10 ohms/square to about 200 ohms/square. The resistance of the second doped layer 164 is lower than that of the first doped layer 162, and thus the front electrode layer 170 may be in contact with the second doped layer 164 to decrease contact resistance.

In one embodiment, the solar cell further includes an anti-reflective layer 180 disposed over the first doped layer 162 and the second doped layer 164 to reduce reflectivity of incident light. In one embodiment, the anti-reflective layer 180 includes silicon nitride.

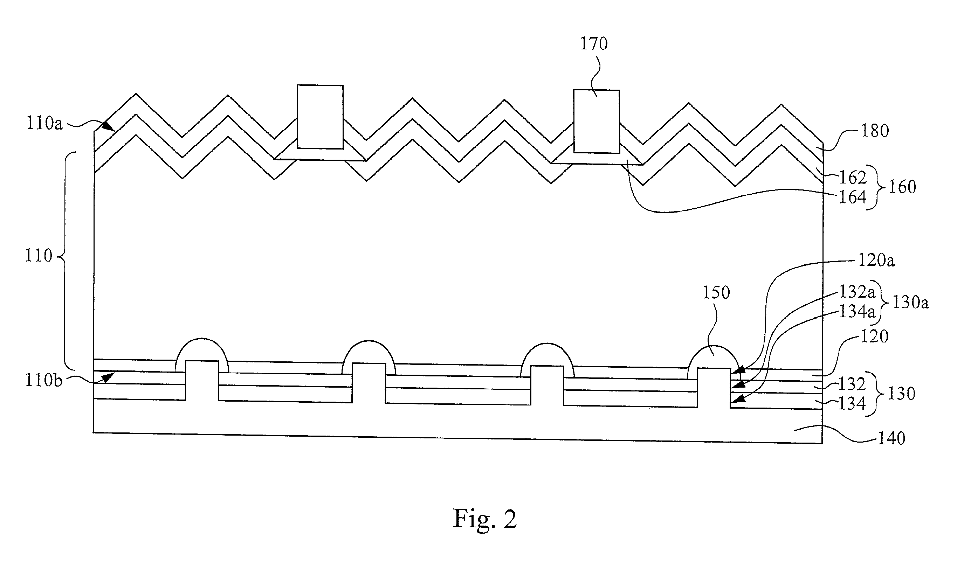

Fig. 2 is a cross-sectional view of a solar cell according to another embodiment of the present disclosure. The difference between Fig. 2 and Fig. 1 is that the back electrode layer 140 of the solar cell of Fig. 2 further covers the passivation layer 130. In other words, the back electrode layer 140 completely covers the passivation layer 130.

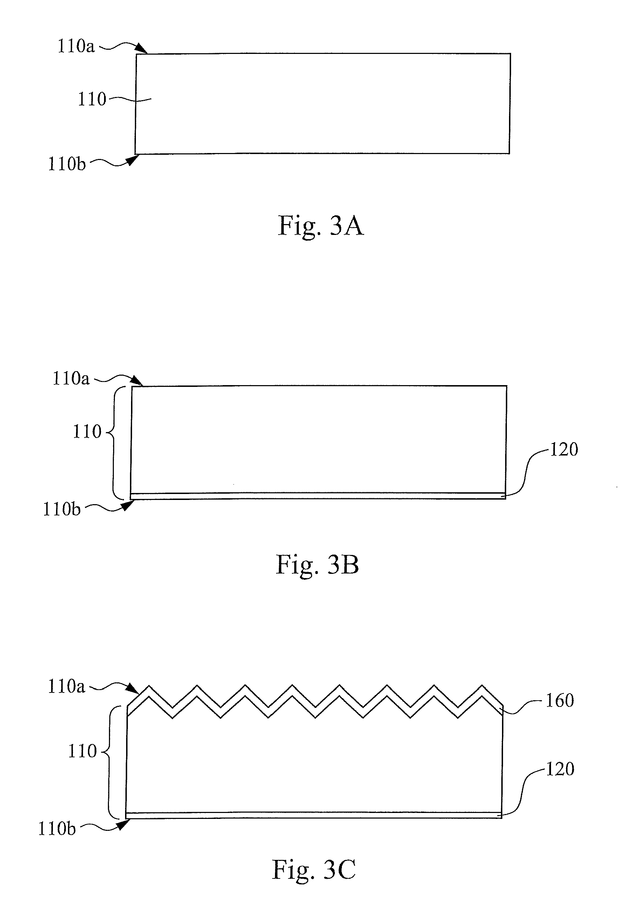

Methods for manufacturing the above-mentioned solar cells are described below. Figs. 3A-3F are cross-sectional views at various stages of manufacturing a solar cell according to one embodiment of the present disclosure. First, as shown in Fig. 3A, a semiconductor substrate 110 is provided, which has a front surface 110a and a back surface 110b opposite to each other.

Next, as shown in Fig. 3B, boron is diffused or ion implanted into the semiconductor substrate 110 beneath the back surface 110b to form a boron BSF layer 120. Before the boron is diffused or ion implanted, a mask (not shown) is formed covering the front surface 110a to avoid boron entering the semiconductor substrate 110 beneath the front surface 110a. After the boron BSF layer 120 is formed, borosilicate glass (not shown) formed accompanied therewith and the mask are removed.

As shown in Fig. 3C, a roughening process is performed on the front surface 110a to form a doped layer 160 in the semiconductor substrate 110 beneath the front surface 110a. Specifically, before the roughening process is performed, a mask (not shown) is formed covering the back surface 110b to protect the boron BSF layer 120. Subsequently, the roughening process is performed to form the rough front surface 110a. Dopants are then diffused into the semiconductor substrate 110 beneath the front surface 110a to form the doped layer 160. For example, the dopants may be phosphorus or other suitable dopants.

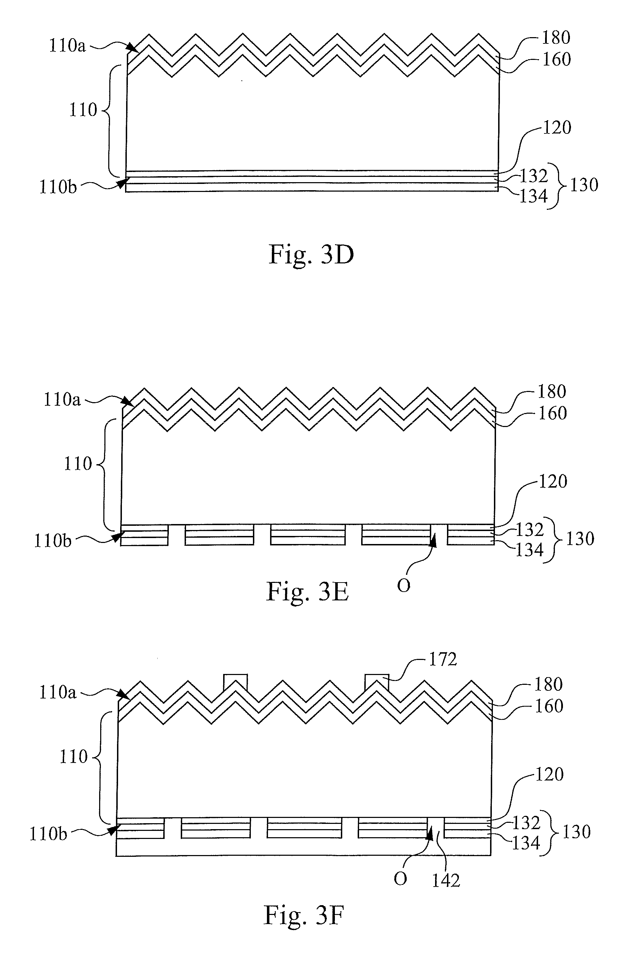

As shown in Fig. 3D, a passivation layer 130 is formed over the boron BSF layer 120. In the embodiment, a first passivation layer 132 and a second passivation layer 134 are sequentially formed over the boron BSF layer 120. In one embodiment, the first passivation layer includes aluminum oxide, silicon oxide or a combination thereof, and the second passivation layer 134 includes silicon nitride, but not limited thereto. The first passivation layer 132 and the second passivation layer 134 may be formed by chemical vapor deposition. In addition, an anti-reflective layer 180 may be formed over the doped layer 160 to reduce reflectivity of incident light. In one embodiment, the anti-reflective layer 180 includes silicon nitride.

As shown in Fig. 3E, an opening O is formed through the passivation layer 130. Specifically, the opening O is through the first passivation layer 132, the second passivation layer 134 and the boron BSF layer 120. For instance, the opening O may be formed by laser or other suitable methods.

As shown in Fig. 3F, an aluminum paste 142 is formed in the opening O. Also, before or after the aluminum paste 142 is formed, a silver paste 172 may be formed over the anti-reflective layer 180. Finally, a sintering operation is performed to sinter the aluminum paste 142 and the silver paste 172 to form an aluminum local BSF layer 150, a back electrode layer 140 and a front electrode layer 170, as shown in Fig. 2. The aluminum local BSF layer 150 is disposed in the semiconductor substrate 110 beneath the openings 130a, 120a.

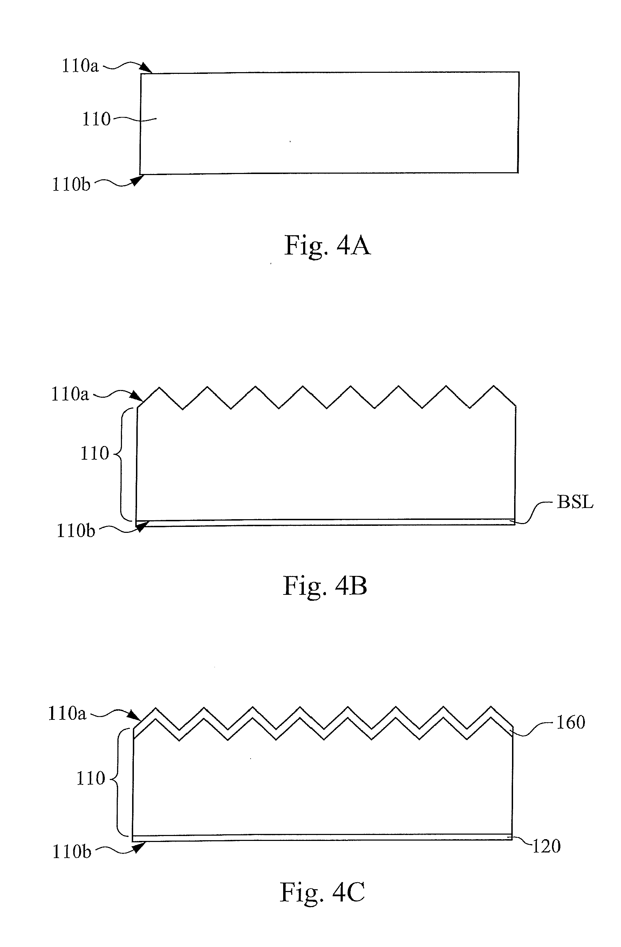

Figs. 4A-4F are cross-sectional views at various stages of manufacturing a solar cell according to another embodiment of the present disclosure. First, as shown in Fig. 4A, a semiconductor substrate 110 is provided, which has a front surface 110a and a back surface 110b opposite to each other.

Subsequently, as shown in Fig. 4B, a roughening process is performed on the front surface 110a, and a boron source layer BSL is then formed over the back surface 110b of the semiconductor substrate 110. In one embodiment, the boron source layer BSL includes boron paste, borosilicate glass or a combination thereof. The boron paste may be coated or printed. The borosilicate glass may be formed using chemical vapor deposition, such as atmospheric pressure chemical vapor deposition (APCVD).

Next, as shown in Figs. 4B-4C, boron of the boron source layer BSL is diffused into the semiconductor substrate 110 beneath the back surface 110b to form a boron BSF layer 120 in the semiconductor substrate 110 beneath the back surface 110b. After the boron BSF layer 120 is formed, the boron source layer BSL is removed. In one embodiment, diffusing the boron of the boron source layer BSL into the semiconductor substrate 110 beneath the back surface 110b and diffusing phosphorus into the semiconductor substrate 110 beneath the front surface 110a to form a doped layer 160 are conducted by a same heat treatment. Therefore, the processing operations can be reduced. Specifically, the structure shown in Fig. 4B may be placed in a high temperature furnace, and phosphorus oxychloride (POCl₃) and oxygen are then fed into the furnace to form the doped layer 160 in the semiconductor substrate 110 beneath the front surface 110a and the boron BSF layer 120 in the semiconductor substrate 110 beneath the back surface 110b. Finally, the boron source layer BSL and phosphorus silicon glass (not shown) formed during diffusing phosphorus are removed.

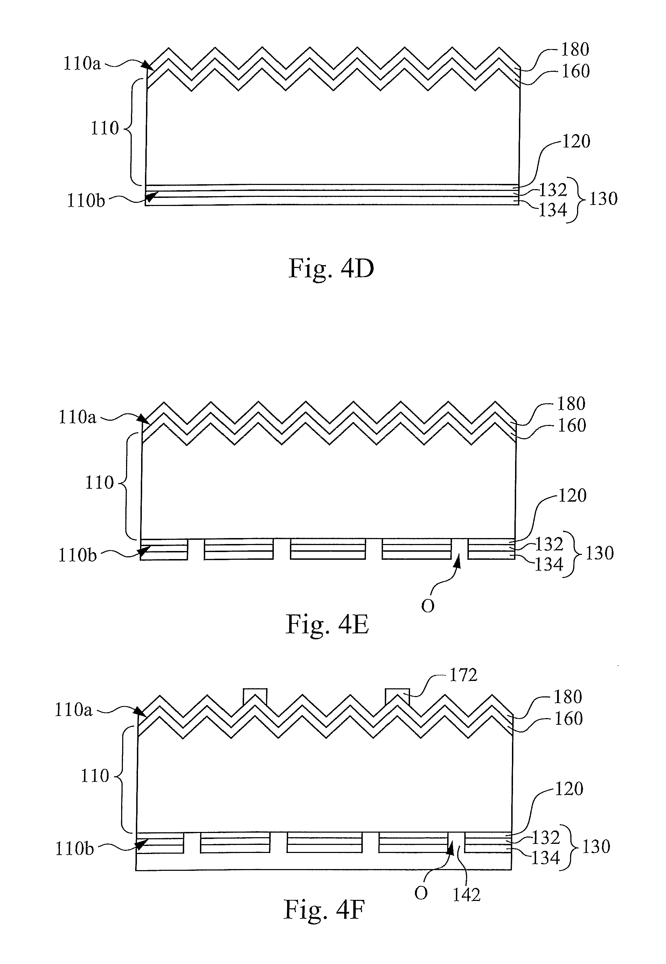

As shown in Fig. 4D, a passivation layer 130 is formed over the boron BSF layer 120. In the embodiment, a first passivation layer 132 and a second passivation layer 134 are sequentially formed over the boron BSF layer 120. Furthermore, an anti-reflective layer 180 may be formed over the doped layer 160 to reduce reflectivity of incident light. In one embodiment, the anti-reflective layer 180 includes silicon nitride.

As shown in Fig. 4E, an opening O is formed through the passivation layer 130. Specifically, the opening O is through the first passivation layer 132, the second passivation layer 134 and the boron BSF layer 120. For instance, the opening O may be formed using laser or other suitable methods.

As shown in Fig. 4F, an aluminum paste 142 is formed in the opening O. A silver paste 172 may also be formed over the anti-reflective layer 180. Finally, a sintering operation is performed to sinter the aluminum paste 142 and the silver paste 172 to form an aluminum local BSF layer 150, a back electrode layer 140 and a front electrode layer 170, as shown in Fig. 2. The aluminum local BSF layer 150 is disposed in the semiconductor substrate 110 beneath the openings 130a, 120a.

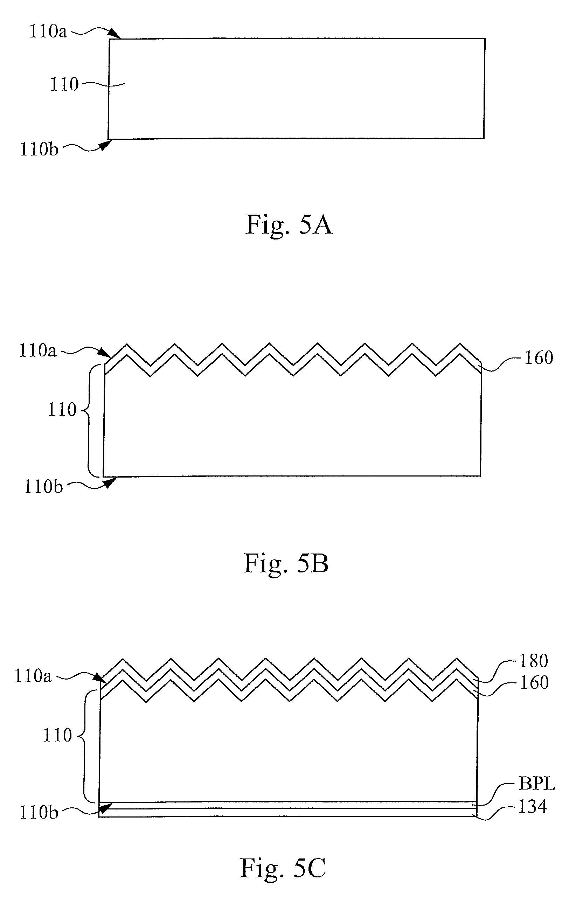

Figs. 5A-5F are cross-sectional views at various stages of manufacturing a solar cell according to further embodiment of the present disclosure. First, as shown in Fig. 5A, a semiconductor substrate 110 is provided, which has a front surface 110a and a back surface 110b opposite to each other.

Next, as shown in Fig. 5B, a roughening process is performed on the front surface 110a, and a doped layer 160 is formed in the semiconductor substrate 110 beneath the front surface 110a. For instance, dopants are diffused into the semiconductor substrate 110 beneath the front surface 110a by high temperature diffusion to form the doped layer 160.

As shown in Fig. 5C, a boron-contained passivation layer BPL is formed over the back surface 110b of the semiconductor substrate 110, and a second passivation layer 134 is formed over the boron-contained passivation layer BPL. The boron-contained passivation layer BPL includes boron and a passivation material. In one embodiment, the boron-contained passivation layer BPL is formed over the back surface 110b using a coating process, such as spray coating. In one embodiment, the passivation material includes aluminum oxide, silicon oxide, silicon oxynitride or a combination thereof, but not limited thereto. In one embodiment, the second passivation layer 134 includes silicon nitride. Further, an anti-reflective layer 180 may be formed over the doped layer 160 to reduce reflectivity of incident light.

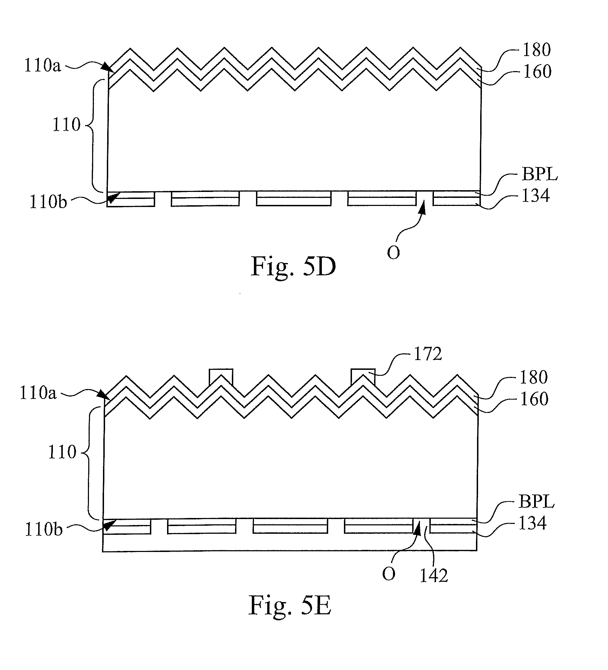

As shown in Fig. 5D, an opening O is formed through the second passivation layer 134 and the boron-contained passivation layer BPL. For example, the opening O is formed using laser or other suitable methods.

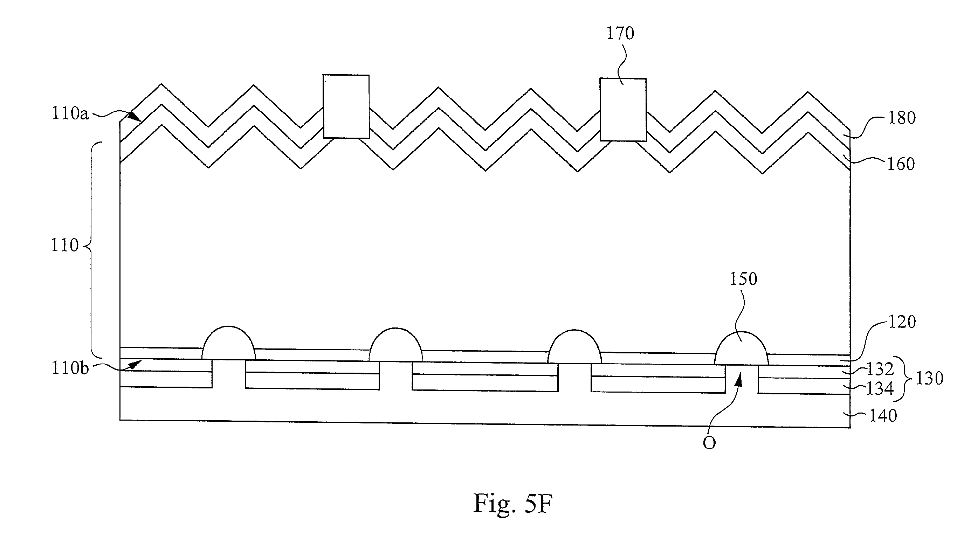

As shown in Fig. 5E, an aluminum paste 142 is formed in the opening O. A silver paste 172 may also be formed over the anti-reflective layer 180. Next, a sintering operation is performed to sinter the aluminum paste 142 and the silver paste 172 to form an aluminum local BSF layer 150, a back electrode layer 140 and a front electrode layer 170, as shown in Fig. 5F. The aluminum local BSF layer 150 is disposed in the semiconductor substrate 110 beneath the opening O. It is noteworthy that, when the aluminum paste 142 and the silver paste 172 are sintered, boron of the boron-contained passivation layer BPL of Fig. 5E will be diffused into the semiconductor substrate 110 beneath the back surface 110b to form the boron BSF layer 120 of Fig. 5F. After the boron of the boron-contained passivation layer BPL is released, a first passivation layer 132 of Fig. 5F is formed. That is, in the embodiment, there is no need for removing the boron-contained passivation layer BPL, and thus processing operations can be reduced.

In accordance with the above, in the methods of the present disclosure, the boron BSF layer and the aluminum local BSF layer are formed without using lithographic and etching processes of semiconductor processes. Accordingly, compared to the methods for manufacturing a solar cell using the lithographic and etching processes, the methods of the present disclosure can be used to significantly reduce process cost and is very practical.

## Claims

1. A solar cell, comprising:
a semiconductor substrate (110) having a front surface (110a) and a back surface (110b) opposite to each other;
a boron back surface field (BSF) layer (120) disposed in the semiconductor substrate (110) beneath the back surface (110b);
a passivation layer (130) disposed over the boron BSF layer (120) and having an opening (130a) through the passivation layer (130);
a back electrode layer (140) disposed in the opening (130a); and
an aluminum local BSF layer (150) disposed in the semiconductor substrate (110) beneath the opening (130a) and in contact with the boron BSF layer (120) and the back electrode layer (140).

2. The solar cell of claim 1, wherein the back electrode layer (140) further covers the passivation layer (130).

3. The solar cell of claim 1, wherein the passivation layer (130) is not completely covered by the back electrode layer (140).

4. The solar cell of claim 1, wherein the boron BSF layer (120) has an opening (120a), and the opening (120a) of the boron BSF layer (120) is substantially aligned with the opening (130a) of the passivation layer (130).

5. The solar cell of claim 1, wherein the passivation layer (130) comprises:
a first passivation layer (132) in contact with the boron BSF layer (120) and comprising aluminum oxide, silicon oxide, silicon oxynitride or a combination thereof; and
a second passivation layer (134) disposed over the first passivation layer (132) and comprising silicon nitride.

6. The solar cell of claim 1, further comprising:
a first doped layer (162) disposed in the semiconductor substrate (110) beneath the front surface (110a);
a second doped layer (164) disposed in the semiconductor substrate (110) beneath the front surface (110a) and adjacent to the first doped layer (162), the first doped layer (162) having a conductivity type the same as a conductivity type of the second doped layer (164), the second doped layer (164) having a doped concentration greater than a doped concentration of the first doped layer (162); and
a front electrode layer (170) in contact with the second doped layer (164).

7. A method for manufacturing a solar cell, comprising:
providing a semiconductor substrate (110) having a front surface (110a) and a back surface (110b) opposite to each other;
forming a boron BSF layer (120) in the semiconductor substrate (110) beneath the back surface (110b);
forming a passivation layer (130) over the boron BSF layer (120);
forming an opening (130a) through the passivation layer (130);
disposing an aluminum paste (142) in the opening (130a); and
sintering the aluminum paste (142) to form an aluminum local BSF layer (150) in the semiconductor substrate (110) beneath the opening (130a).

8. The method of claim 7, wherein forming the boron BSF layer (120) in the semiconductor substrate (110) beneath the back surface (110b) is conducted by diffusing or ion implanting boron into the semiconductor substrate (110) beneath the back surface (110b).

9. The method of claim 7, wherein forming the boron BSF layer (120) in the semiconductor substrate (110) beneath the back surface (110b) comprises:
forming a boron-containing passivation material layer (BPL) over the back surface (110b) of the semiconductor substrate (110), the boron-containing passivation material layer (BPL) comprising boron and a passivation material; and
diffusing the boron of the boron-containing passivation material layer (BPL) into the semiconductor substrate (110) beneath the back surface (110b) to form the boron BSF layer (120).

10. The method of claim 9, wherein diffusing the boron of the boron-containing passivation material layer (BPL) into the semiconductor substrate (110) beneath the back surface (110b) and sintering the aluminum paste (142) are simultaneously performed.

11. The method of claim 7, wherein forming the boron BSF layer (120) in the semiconductor substrate (110) beneath the back surface (110b) comprises:
forming a boron source layer (BSL) over the back surface (110b) of the semiconductor substrate (110);
diffusing boron of the boron source layer (BSL) into the semiconductor substrate (110) beneath the back surface (110b) to form the boron BSF layer (120); and
removing the boron source layer (BSL).

12. The method of claim 11, wherein the boron source layer (BSL) comprises boron paste, borosilicate glass or a combination thereof.

13. The method of claim 11, further comprising diffusing phosphorus into the semiconductor substrate (110) beneath the front surface (110a).

14. The method of claim 13, wherein diffusing the boron of the boron source layer (BSL) into the semiconductor substrate (110) beneath the back surface (110b) and diffusing the phosphorus into the semiconductor substrate (110) beneath the front surface (110a) are conducted by a same heat treatment.
